# EUROPEAN PATENT SPECIFICATION

(11) **EP 3 176 947 B1**
(45) Date of publication and mention of the grant of the patent: **03.07.2019**
(21) Application number: 16199520.4
(22) Date of filing: 18.11.2016
(51) Int. Cl.: H03H 1/00, H03H 7/42, H03H 7/09, H03H 7/01, H02M 1/12

(54) **NOISE FILTER CIRCUIT SUBSTRATE AND METHOD OF MANUFACTURING THE SAME**
SUBSTRAT FÜR EINE RAUSCHFILTERSCHALTUNG UND VERFAHREN ZUR HERSTELLUNG DAVON
SUBSTRAT DE CIRCUIT DE FILTRE DE BRUIT ET SON PROCÉDÉ DE FABRICATION

(30) Priority: 01.12.2015 JP 2015234873
(43) Date of publication of application: 07.06.2017
(73) Proprietor: MITSUBISHI HEAVY INDUSTRIES THERMAL SYSTEMS, LTD., Tokyo 108-8215 (JP)
(72) Inventor: ADACHI, Naoya, MINATO-KU, TOKYO, 108-8215 (JP)
(74) Representative: Desormiere, Pierre-Louis

(56) References cited:
- EP-A1- 1 696 559
- JP-A- 2009 267 596
- US-A1- 2009 058 560
- US-A1- 2010 188 168

## Description

### Technical field

The present invention relates to a circuit substrate and a method of manufacturing the same.

### Background art

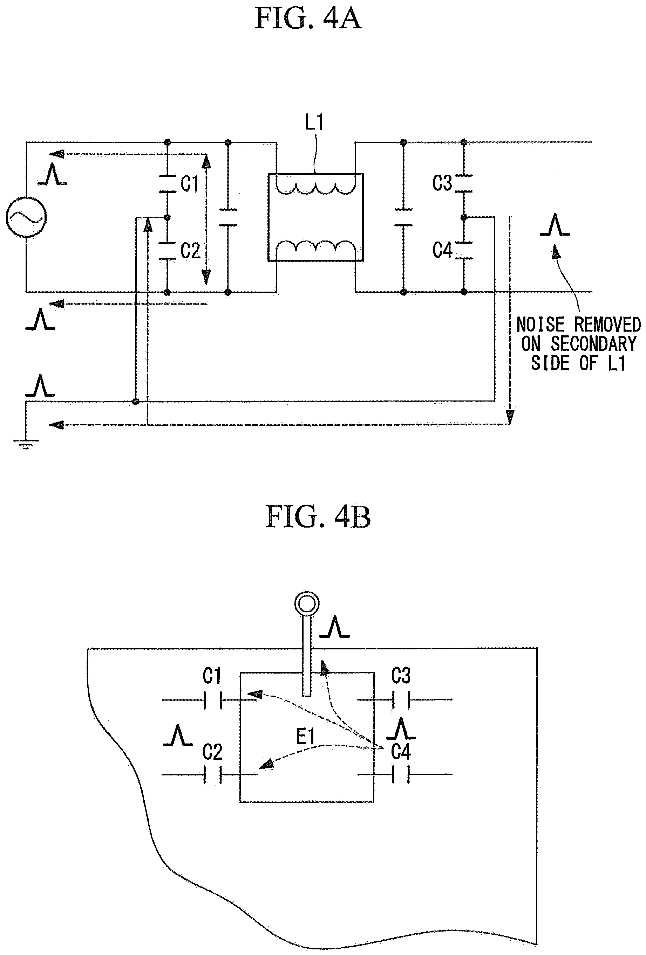

A noise filter circuit is known which includes a common-mode choke coil L1, line-to-line capacitors, line-to-ground capacitors (C1 C2/C3 and C4), and a ground plane E1 (see Figs. 4A and 4B). In the noise filter circuit as shown in Fig. 4A, noise removed by the line-to-ground capacitors C3 and C4 on the secondary side of the common-mode choke coil L1 propagates through the ground plane E1, through the line-to-ground capacitors C1 and C2 and then is superimposed on the primary side of the common-mode choke coil L1, as shown in Fig. 4B, which increases the level of noise in noise terminal-voltage. Therefore, a method to solve this problem has been proposed.

Patent Literature PTL 1 discloses, as shown in Fig. 5 thereof, a noise filter circuit having a plurality of ground patterns GND1 and GND2, in which the adjacent substrate ground patterns (GND1 and GND2) are disposed such that the spacing between them is a predetermined distance or less. PTL 1 proposes a configuration in which the first common-mode choke coil is disposed to overlaps both the first substrate ground pattern GND1 and the second substrate ground pattern GND2.

### Patent Literature

A noise filter is disclosed in PCT International Publication No. WO 2015/056321 (PTL1). Note also EP1696559 and US2010/0188168.

### SUMMARY OF INVENTION

### Technical Problem

However, the method disclosed in PTL 1 requires two grounds. The problem therefore arises that two grounds can barely be provided in a limited space, such as indoor unit of an air conditioner which has a small work space compared to outdoor unit.

An object of the present invention, which has been made in this background, is to provide a space-saving circuit substrate that can remove noise as much as possible, and a method of manufacturing the same.

### Solution to Problem

The first aspect of the present invention is a circuit substrate according to claim 1.

In this manner, the single ground plane pattern is provided which is connected to the first wire connected to the primary side and the second wire connected to the secondary side and the plane pattern is divided between the first wire and the second wire. With this configuration, noise removed on the secondary side is not superimposed on the primary side through the ground plane pattern and the first wire. Thus, with the single ground plane pattern, the effects of saving space and removing noise as much as possible can be provided.

In the plane pattern of the above circuit substrate, the plane pattern may be divided between portions on the primary side connected to different phases and/or between portions on the secondary side connected to different phases.

Dividing the plane pattern between different phases on the primary side or between different phases on the secondary side prevents noise from being superimposed on other phases.

The second aspect of the present invention is a method of manufacturing a circuit substrate according to claim 3.

### Advantageous Effects of Invention

The present invention provides advantageous effects of saving space and removing noise as much as possible.

### Brief Description of Drawings

Fig. 1 is a circuit block diagram of the present invention;
Fig. 2 is a schematic diagram of a circuit pattern of the present invention;
Fig. 3 is a schematic diagram of a circuit pattern of another example of the present invention;
Fig. 4A is an example of an exemplary conventional circuit block diagram;
Fig. 4B is a schematic diagram of the circuit pattern in the circuit block diagram of Fig. 4A; and

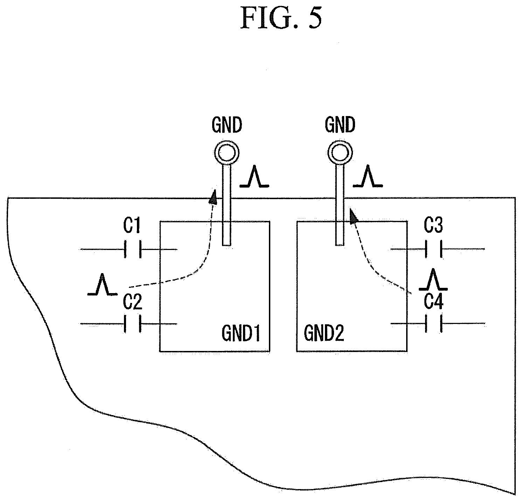

Fig. 5 is an example of another exemplary conventional circuit block diagram.

### Description of Embodiments

A circuit substrate according to an embodiment of the present invention and a method of manufacturing the same will now be described with reference to the drawings. The circuit substrate according to this embodiment is supposed to be mounted to a control device for indoor unit of an air conditioner, which should not be construed to limit the present invention.

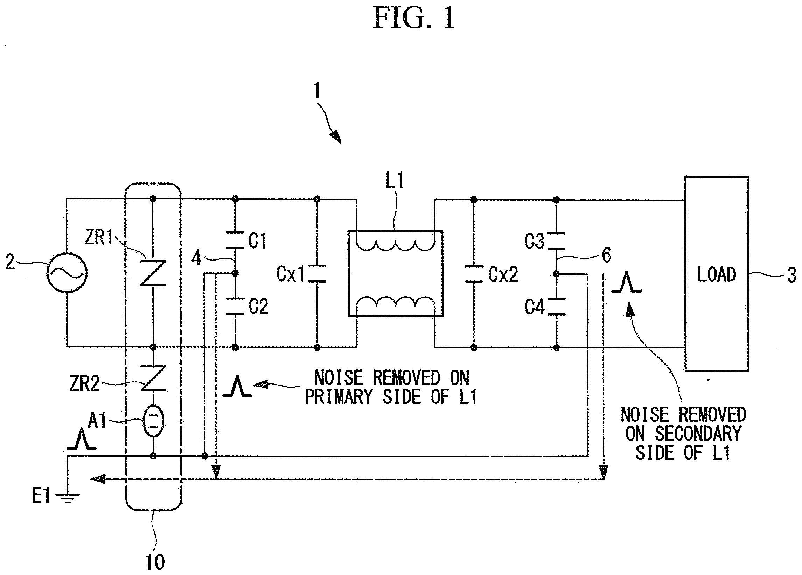

Fig. 1 shows a block diagram of a circuit substrate according to this embodiment.

A circuit substrate 1 is connected between a power source 2 and a load 3 receiving electric power from the power source 2. The circuit substrate 1 includes a first circuit 10, line-to-line capacitors CX1 and CX2, line-to-ground capacitors C1 and C2/C3 and C4, and a common-mode choke coil (filter circuit) L1. The ground is a ground plane pattern (plane pattern for ground) E1.

The first circuit 10 includes a first varistor ZR1, a second varistor ZR2, and an arrester A1, and serves as a circuit for protection from a lightning surge.

The common-mode choke coil L1 is a filter for removing common-mode noise superimposed on the power source (AC line) 2.

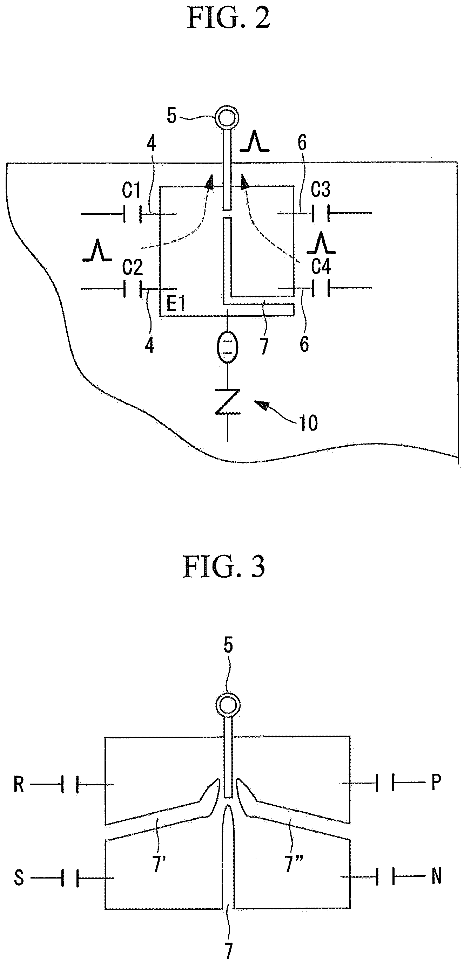

The ground plane pattern E1 is a ground (GND) land which is connected to a ground terminal 5 (see Fig. 2). In the circuit substrate 1 shown in Fig. 1, the ground plane pattern E1 is connected to a first wire 4 connected to the capacitors C1 and C2 disposed on the primary side of the common-mode choke coil L1, and to a second wire 6 connected to the capacitors C3 and C4 disposed on the secondary side of the common-mode choke coil L1.

As shown in Fig. 2, the ground plane pattern E1 also includes a cutout 7 in the ground plane pattern E1 between the primary side and the secondary side of the common-mode choke coil L1 so that noise removed on the secondary side cannot be superimposed on the primary side through the ground plane pattern E1 and other elements. Thus, the primary side and the secondary side of the common mode choke coil is separated in the ground land.

Since the primary side and the secondary side of the common-mode choke coil L1 are separated in the ground plane pattern E1, noise removed by the secondary side is not superimposed on the primary side through other elements (e.g., the capacitors C1 and C2).

Besides, even if some part of the ground plane pattern E1 lies between the cutout 7 and the ground terminal 5 of the ground plane pattern E1 as shown in Fig. 2, high impedance prevents noise removed by the capacitors C3 and C4 from being superimposed on the capacitor C1 side through this some part of the ground plane pattern E1.

The effects of the circuit substrate 1 will now be described.

When noise occurs having a level exceeding a predetermined limit value in a voltage from the power source 2, the line-to-line capacitors CX1 and CX2 reduce differential-mode noise to the limit value or below. Common-mode noise is removed from the common-mode choke coil L1 and common-mode noise current is released to the ground plane pattern E1 through the capacitors C3 and C4 on the secondary side. Although the ground plane pattern E1 is connected to the capacitors C1 and C2 on the primary side of the common-mode choke coil L1, the cutout 7 between the second wire 6, connected to the capacitors C3 and C4 on the secondary side, and the first wire 4, connected to the capacitors C1 and C2 on the primary side, prevents noise removed on the secondary side from being superimposed on the primary side.

As described above, in the circuit substrate 1 and the method of manufacturing the same according to this embodiment, the single ground plane pattern E1 connected to the capacitors C1 and C2, which are connected to the first wire 4 connected to the primary side before noise is removed by the common-mode choke coil L1, and to the capacitors C3 and C4, which are connected to the second wire 6 connected to the secondary side from which the noise is removed through the common-mode choke coil L1, is divided, by the cutout 7, between the portion connected to the capacitors C1 and C2 and the portion connected to the capacitors C3 and C4.

In this manner, the single ground plane pattern E1 connected to the first wire 4 connected to the primary side and the second wire 6 connected to the secondary side, the plane pattern is divided between the first wire 4 and the second wire 6. Hence, noise removed by the capacitors C3 and C4 on the secondary side is not superimposed on the capacitors C1 and C2 on the primary side through the ground plane pattern E1 and the first wire 4. Thus, with the single ground plane pattern E1, the effects of saving space and removing noise as much as possible can be provided.

Although the embodiment of the present invention has been described with reference to the drawings, the specific configuration of the invention is not limited to this embodiment and includes design modifications without departing from the scope of the invention. For example, the cutout is provided in the common-mode choke coil L1 between the secondary side and the primary side to divide the ground land in the above embodiment, although the approach for dividing the ground land is not limited to this.

The ground land may be divided between portions on the primary side connected to different phases, and/or between portions on the secondary side connected to different phases.

To be specific, as shown in Fig. 3, a cutout 7' may be provided between the phase R and the phase S on the primary side and/or a cutout 7" may be provided between the phase P and the phase N on the secondary side. Dividing the ground plane pattern E1 between different phases on the primary side or different phases on the secondary side in this manner prevents noise from being superimposed on other phases.

### Reference Signs List

- 1: circuit substrate
- 2: power source
- 3: load
- 5: ground terminal
- 7: cutout
- L1: common-mode choke coil (filter circuit)
- C1, C2, C3, C4, CX1, CX2: capacitor
- E1: ground plane pattern

## Claims

1. A circuit substrate (1) comprising:
a single ground plane pattern (E1); and
a filter circuit (L1) for removing noise propagated from a power source line (2), wherein
the single ground plane pattern is connected to a first wire (4) connected to a primary side of the filter circuit upstream of where the noise is removed by the filter circuit and to a second wire (6) connected to a secondary side of the filter circuit downstream of where the noise is removed by the filter circuit, the ground plane pattern is divided into a portion connected to the first wire (4) and a portion connected to the second wire (6), and a cutout (7, 7', 7") is provided in the single ground plane pattern between the portion connected to the first wire (4) and the portion connected to the second wire (6).

2. The circuit substrate according to Claim 1, wherein
the plane pattern is divided between portions on the primary side connected to different phases and/or between portions on the secondary side connected to different phases.

3. A method of manufacturing a circuit substrate (1) with a single ground plane pattern (E1) and a filter circuit removing noise (L1) propagated from a power source line (2), comprising the steps of:
connecting to the single ground plane pattern a first wire (4) connected to a primary side of the filter circuit upstream of where the noise is removed by the filter circuit, and a second wire (6) connected to a secondary side of the filter circuit downstream of where the noise is removed by the filter circuit; and
dividing the plane pattern into a portion connected to the first wire (4) and a portion connected to the second wire (6) by providing a cutout (7, 7', 7") in the single ground plane pattern between the portion connected to the first wire (4) and the portion connected to the second wire (6).

## Patentansprüche

1. Schaltungssubstrat (1), umfassend:
ein einzelnes Masseflächenmuster (E1) und
eine Filterschaltung (L1) zum Entfernen von Rauschen, das sich von einer Energiequellenleitung (2) ausbreitet, wobei
das einzelne Masseflächenmuster mit einem ersten Draht (4) verbunden ist, der mit einer Primärseite der Filterschaltung stromauf des Ortes, wo das Rauschen durch die Filterschaltung entfernt wird, verbunden ist, und mit einem zweiten Draht (6) verbunden ist, der mit einer Sekundärseite der Filterschaltung stromab des Ortes, wo das Rauschen durch die Filterschaltung entfernt wird, verbunden ist, das Masseflächenmuster in einen Abschnitt, der mit dem ersten Draht (4) verbunden ist, und einen Abschnitt, der mit dem zweiten Draht (6) verbunden ist, geteilt ist und eine Aussparung (7, 7', 7") in dem einzelnen Masseflächenmuster zwischen dem Abschnitt, der mit dem ersten Draht (4) verbunden ist, und dem Abschnitt, der mit dem zweiten Draht (6) verbunden ist, vorgesehen ist.

2. Schaltungssubstrat nach Anspruch 1, wobei
das Flächenmuster auf Abschnitte auf der Primärseite, die mit verschiedenen Phasen verbunden sind, und/oder auf Abschnitte auf der Sekundärseite, die mit verschiedenen Phasen verbunden sind, aufgeteilt ist.

3. Verfahren zum Herstellen eines Schaltungssubstrats (1) mit einem einzelnen Masseflächenmuster (E1) und einer Filterschaltung, die Rauschen (L1) entfernt, das sich von einer Energiequellenleitung (2) ausbreitet, umfassend folgende Schritte:
Verbinden eines ersten Drahts (4), der mit einer Primärseite der Filterschaltung stromauf des Ortes verbunden ist, wo das Rauschen durch die Filterschaltung entfernt wird, und eines zweiten Drahts (6), der mit einer Sekundärseite der Filterschaltung stromab des Ortes verbunden ist, wo das Rauschen durch die Filterschaltung entfernt wird, mit dem einzelnen Masseflächenmuster und
Unterteilen des Flächenmusters in einen Abschnitt, der mit dem ersten Draht (4) verbunden ist, und einen Abschnitt, der mit dem zweiten Draht (6) verbunden ist, durch Vorsehen einer Aussparung (7, 7', 7") in dem einzelnen Masseflächenmuster zwischen dem Abschnitt, der mit dem ersten Draht (4) verbunden ist, und dem Abschnitt, der mit dem zweiten Draht (6) verbunden ist.

## Revendications

1. Substrat de circuit (1) comprenant :
un motif de plan de masse unique (E1) ; et
un circuit de filtre (L1) pour éliminer le bruit propagé à partir d'une ligne de source d'alimentation (2), dans lequel le motif de plan de masse unique est connecté à un premier fil (4) connecté à un côté primaire du circuit de filtre en amont de là où le bruit est éliminé par le circuit de filtre et à un second fil (6) connecté à un côté secondaire du circuit de filtre en aval de là où le bruit est éliminé par le circuit de filtre, le motif de plan de masse est divisé en une partie connectée au premier fil (4) et une partie connectée au second fil (6), et une découpe (7, 7', 7") est formée dans le motif de plan de masse unique entre la partie connectée au premier fil (4) et la partie connectée au second fil (6).

2. Substrat de circuit selon la revendication 1, dans lequel
le motif de plan est divisé entre des parties sur le côté primaire connectées à des phases différentes et/ou entre des parties sur le côté secondaire connectées à des phases différentes.

3. Procédé de fabrication d'un substrat de circuit (1) ayant un motif de plan de masse unique (E1) et un circuit de filtre éliminant le bruit (L1) propagé à partir d'une ligne de source d'alimentation (2), comprenant les étapes consistant à :
connecter au motif de plan de masse unique un premier fil (4) connecté à un côté primaire du circuit de filtre en amont de là où le bruit est éliminé par le circuit de filtre, et un second fil (6) connecté à un côté secondaire du circuit de filtre en aval de là où le bruit est éliminé par le circuit de filtre ; et
diviser le motif de plan en une partie connectée au premier fil (4) et une partie connectée au second fil (6) en formant une découpe (7, 7', 7") dans le motif de plan de masse unique entre la partie connectée au premier fil (4) et la partie connectée au second fil (6).
